# FASCICULE DE BREVET EUROPEEN

(11) **EP 0 645 884 B1**
(45) Date de publication et mention de la délivrance du brevet: **15.09.1999**
(21) Numéro de dépôt: 94402120.3
(22) Date de dépôt: 23.09.1994
(51) Int. Cl.: H03F 1/48, H03F 3/45, H03F 3/345

(54) **Chaîne d'amplification en mode de courant, amplificateur opérationnel, cellule de gain et élément d'amplification correspondants**
Verstärkerkette in Strommode, Operationsverstärker, Verstärkungszelle und zugehöriges Verstärkerelement
Current mode amplifier chain, operational amplifier, gain cell and corresponding amplifying elements

(30) Priorité: 27.09.1993 FR 9311455
(43) Date de publication de la demande: 29.03.1995
(73) Titulaire: ALCATEL, 75008 Paris (FR)
(72) Inventeur: Genest, Pierre, F-95430 Butry sur Oise (FR)
(74) Mandataire: El Manouni, Josiane

(56) Documents cités:
- EP-A- 0 011 446
- EP-A- 0 275 940
- EP-A- 0 521 215
- WO-A-90/01831
- FR-A- 1 556 106
- IEEE INTERNATIONAL SOLID STATE CIRCUITS CONFERENCE, vol.34, Février 1991, NEW YORK US pages 278 - 329, XP238339 G. NICOLLINI ET AL 'A-78DB THD 100 OHM DIFFERENTIAL DRIVER FOR ISDN APPLICATIONS'

## Description

Le domaine de l'invention est celui du traitement analogique d'un signal. Un tel traitement, qui consiste notamment à filtrer et/ou amplifier un signal, par exemple avant sa conversion en numérique, ne peut être effectué que sur un signal possédant une énergie suffisante car ce traitement consomme généralement beaucoup d'énergie. Or, d'une façon générale, un signal à traiter est un signal à faible énergie et il convient donc d'amplifier préalablement l'énergie de ce signal avant son traitement.

L'invention concerne précisément une chaîne d'amplification pouvant être réalisée sous la forme d'un amplificateur opérationnel et permettant une telle amplification de l'énergie d'un signal afin que son traitement soit possible.

On connaît, dans l'état de la technique proche de l'invention, deux types d'amplificateurs opérationnels, à savoir l'amplificateur opérationnel en mode de tension et l'amplificateur opérationnel en mode de courant. Chacun de ces deux types d'amplificateur opérationnel comprend généralement une ou deux cellules de gain. Il existe également un autre type d'amplificateur opérationnel, à savoir l'amplificateur mixte à entrée en tension et contre-réaction en courant. Ce dernier type d'amplificateur n'appartenant pas à l'état de la technique proche de l'invention, il ne sera pas discuté par la suite.

L'amplificateur opérationnel en mode de courant présente un large bande passante et une bonne précision pour la définition du gain mais, malheureusement, ce gain ne peut pas prendre une valeur élevée car la valeur du gain d'une cellule de gain en mode de courant ne peut être importante. Des exemples d'une telle cellule de gain sont connus de WO-A-90/01831

En mode de courant, l'amplification proprement dite est généralement basée sur l'utilisation d'un mélangeur translinéaire. Or, avec un mélangeur translinéaire, si les deux courants de polarisation appliqués aux deux noeuds d'entrée se trouvent modulés par un courant de mode commun, le gain, qui est un gain différentiel proportionnel au rapport entre ces deux courants de polarisation, se trouve également modulé. En d'autres termes, il peut exister un gain de mode commun indésirable.

L'amplificateur opérationnel en mode de tension présente quant à lui un gain élevé, mais, en contrepartie, il présente de nombreux inconvénients. En effet, la valeur de ce gain est difficile à contrôler. La consommation énergétique ne peut être faible qu'au détriment de la rapidité. De même, l'obtention d'une large bande passante nécessite une importante consommation de courant. Enfin, dans le cas des filtres, l'atténuation des signaux rapides rend nécessaire l'utilisation de courants de polarisation importants.

Afin d'obtenir un gain élevé tout en conservant la plupart des avantages liés au mode de courant, une solution connue consiste à mettre en cascade, généralement à l'intérieur d'un même amplificateur opérationnel, un nombre important de cellules de gain en mode de courant. Ainsi, on allie les avantages du mode de courant, à savoir notamment une bonne précision sur le gain, avec un gain élevé obtenu grâce à la structure en cascade.

Toutefois, cette solution connue présente un inconvénient majeur qui est le risque d'instabilité en phase. En effet, lors de son passage à travers chacune des cellules de gain de la chaîne d'amplification, le signal subit une rotation de phase.

La rotation de phase totale en sortie de l'amplificateur en mode de courant est égale au cumul des rotations de phase induites par les différentes cellules. La structure en cascade de cet amplificateur comportant un nombre important de cellules de gain, la rotation de phase totale en sortie est généralement élevée. Il est donc clair que, dans la plupart des cas, cette rotation de phase totale entraîne une instabilité de l'amplificateur opérationnel en mode rebouclé.

Afin de lutter contre une telle instabilité, et présenter en sortie une marge de phase suffisante, on a pensé à créer un pôle dominant en travaillant en basses fréquences. Mais le fait de ne pouvoir travailler qu'en basses fréquences, qui se traduit par une perte de bande passante du signal amplifié, rend cette solution peu attractive puisqu'elle supprime un des principaux avantages du mode de courant, à savoir une large bande passante.

De plus, les amplificateurs en mode courant connus de l'état de la technique sont soumis à plusieurs autres contraintes telles que, notamment, un bruit et un offset de courant faibles, et une rapidité élevée.

L'offset de courant, qui vient s'ajouter à la différence de courant à amplifier, provient de l'imperfection des appariements de transistors et ne peut être atténué que par le choix de "gros" transistors sur lesquels il est plus aisé d'obtenir une bonne précision géométrique. De même, le bruit généré par les transistors, qui est dépendant du rapport W/L du composant (MOS par exmple), est plus faible pour les gros transistors que pour les petits. Malheureusement, les gros transistors présentent l'inconvénient d'être lents (puisque leur rapport W/L est faible), c'est-à-dire de ne pouvoir travailler qu'en basses fréquences, et seuls les petits transistors, qui possèdent une géométrie minimale, peuvent travailler en hautes fréquences.

Par conséquent, il convient d'effectuer un compromis entre d'une part la rapidité et d'autre part l'offset de courant et le bruit.

L'invention a notamment pour objectif de pallier ces différents inconvénients de l'état de la technique.

Plus précisément, un objectif de l'invention est de fournir une chaîne d'amplification en mode de courant qui possède un gain élevé et une bonne précision pour la définition de ce gain.

Un autre objectif de l'invention est de fournir une telle chaîne d'amplification qui soit stable en phase (c'est-à-dire qui présente une marge de phase suffisante en sortie) et possède une large bande passante.

Un autre objectif de l'invention est de fournir une telle chaîne d'amplification qui présente une faible consommation tout en étant rapide et donc à large bande passante.

Un objectif complémentaire de l'invention est de fournir une telle chaîne d'amplification qui soit rapide tout en présentant un bruit réduit et un faible offset de courant.

L'invention a également pour objectif de fournir une telle chaîne d'amplification qui présente une bonne réjection de mode commun.

Un autre objectif de l'invention est de fournir une telle chaîne qui puisse être réalisée avec des transistors aussi bien de type bipolaire que de type MOS.

Ces objectifs ainsi que d'autres qui apparaîtront par la suite, sont atteints selon l'invention à l'aide d'une chaîne d'amplification en mode de courant comprenant une première cellule de gain et au moins une seconde cellule de gain montées en cascade,
ladite première cellule de gain comprenant :
- des moyens d'amplification recevant un courant d'entrée de ladite chaîne d'amplification et délivrant un courant amplifié de sortie ;
- des moyens de filtrage passe-bas recevant ledit courant amplifié de sortie desdits moyens d'amplification de ladite première cellule de gain, et délivrant un courant de sortie amplifié et filtré ;
ladite seconde cellule de gain comprenant :
- des moyens d'amplification comportant d'une part une première entrée recevant le courant de sortie amplifié et filtré de la cellule de gain précédente dans ladite cascade et d'autre part une seconde entrée recevant le courant d'entrée de ladite chaîne d'amplification, et délivrant un courant amplifié de sortie ;
- des moyens d'activation/désactivation de ladite seconde entrée ;
- des moyens de filtrage passe-bas recevant ledit courant amplifié de sortie desdits moyens d'amplification de ladite seconde cellule de gain, et délivrant un courant de sortie amplifié et filtré,
lesdits moyens de filtrage passe-bas de chacune desdites cellules de gain montées en cascade possèdant une fréquence de coupure haute, l'ordre croissant des fréquences de coupure hautes correspondant à l'ordre de cascade des cellules de gain, de l'entrée vers la sortie de ladite chaîne d'amplification.

Le principe de l'invention consiste donc à décaler les fréquences de coupure hautes des moyens de filtrage passe-bas des cellules, et à réinjecter le courant d'entrée de l'amplificateur opérationnel dans chacune des secondes cellules de gain, par l'intermédiaire d'une seconde entrée présente sur les moyens d'amplification de chacune de ces secondes cellules de gain.

En d'autres termes, les cellules de gain sont cascadées dans un ordre croissant de rapidité (c'est-à-dire que l'ordre des cellules est fonction de leur capacité à travailler sur une bande de fréquences de plus en plus large).

De cette façon, on réalise une compensation sur une large bande de fréquences, cette compensation étant telle que la rotation de phase du courant de sortie des moyens d'amplification d'une cellule de gain est masquée dans la cellule de gain suivante. Cette compensation se produit lorsque le courant amplifié par cette cellule de gain suivante, qui était auparavant constitué du courant de sortie de la cellule de gain précédente, devient essentiellement constitué du courant d'entrée réinjecté.

La rotation de phase induite par une cellule se produisant pour des fréquences proches de la fréquence de coupure haute des moyens de filtrage passe-bas de cette cellule, la compensation sera d'autant meilleure que les fréquences de coupure hautes seront éloignées les unes des autres. En effet, si la bande de fréquences entre deux fréquences de coupure hautes est suffisamment large, on évite un cumul de rotation de phase pouvant conduire à une marge de phase inacceptable (c'est-à-dire à une instabilité en sortie de l'amplificateur opérationnel).

La structure en cascade permet quant à elle d'obtenir un gain élevé.

De plus, l'utilisation du mode de courant, permet d'obtenir une bonne précision sur ce gain, et une consommation réduite du fait que les courants de polarisation peuvent être plus faibles qu'en mode de tension.

Dans un mode de réalisation avantageux de l'invention, lesdits moyens d'activation/désactivation de la seconde entrée des moyens d'amplification de ladite seconde cellule de gain sont du type passe-haut et possèdent une fréquence de coupure basse, ladite seconde entrée étant activée pour les fréquences supérieures à ladite fréquence de coupure basse et désactivée pour les autres fréquences, l'ordre croissant desdites fréquences de coupure basses correspondant audit ordre de cascade des cellules de gain, de l'entrée vers la sortie de ladite chaîne d'amplification.

Ainsi, les moyens d'activation/désactivation de la seconde entrée des moyens d'amplification de chacune des secondes cellules de gain permettent l'injection d'un courant de compensation correspondant à une bande haute de fréquences du courant d'entrée de la chaîne d'amplification. Cette bande haute est en quelque sorte filtrée par ces moyens d'activation/désactivation et est sensiblement égale à la bande de fréquences complémentaire de la bande de fréquences situées en dessous de la fréquence de coupure haute des moyens de filtrage passe-bas de la cellule de gain précédente. Cette bande haute est de plus en plus étroite, ce qui correspond à un filtrage progressif du courant d'entrée réinjecté, et permet de compenser la rotation de phase induite par chaque cellule de gain.

Avantageusement, la fréquence ce coupure basse des moyens d'activation/désactivation de ladite seconde entrée de la seconde cellule de gain est sensiblement inférieure à la fréquence de coupure haute des moyens de filtrage passe-bas de la cellule de gain précédente.

De cette façon, on optimise, après chaque amplification, la compensation de la rotation de phase effectuée dans chaque cellule de gain.

De façon avantageuse, ladite chaîne d'amplification comprend une cellule d'entrée, placée en amont de ladite cascade de cellules de gain et recevant ledit courant d'entrée de la chaîne d'amplification, ladite cellule d'entrée possédant une très faible impédance d'entrée, ladite cellule d'entrée comprenant des moyens d'addition et délivrant un courant égal à la somme du courant d'entrée d'amplificateur et d'un courant continu de polarisation.

Avantageusement, ladite chaîne d'amplification comprend une cellule de sortie, placée en aval de ladite cascade de cellules de gain et recevant le courant de sortie de la dernière cellule de gain, ladite cellule de sortie possédant une très forte impédance de sortie.

Ainsi, cette cellule d'entrée et cette cellule de sortie permettent une adaptation d'impédance respectivement en entrée et en sortie de l'amplificateur opérationnel.

Dans un mode de réalisation préférentiel de l'invention, lesdits moyens d'amplification d'une cellule de gain comprennent un premier et un second multiplieurs translinéaires symétriques l'un par rapport à l'autre et combinés de façon que les sorties desdits premier et second multiplieurs translinéaires soient communes et constituent la sortie desdits moyens d'amplification, chacun desdits premier et second multiplieurs translinéaires comprenant deux transistors d'entrée et au moins une paire différentielle de transistors de sortie.

De cette façon, sans augmenter la consommation par rapport à une structure classique à un seul multiplieur translinéaire, on double le gain de la cellule. De plus, avec cette structure à deux multiplieurs symétriques, les transistors d'entrée sont traversés par le même courant, ce qui permet d'améliorer la linéarité de l'ensemble ainsi que la réponse en fréquence.

Préférentiellement, lesdits moyens d'amplification de ladite première cellule de gain comprennent :
- un premier étage de polarisation comprenant notamment au moins deux premiers miroirs de courant constitués chacun de deux transistors et permettant une polarisation de la ou des paires différentielles de transistors de sortie dudit premier multiplieur translinéaire et constituant une masse virtuelle pour les transistors d'entrée dudit premier multiplieur translinéaire ;
- un étage complémentaire d'amplification comprenant notamment au moins deux seconds miroirs de courant, constitués chacun de deux transistors, lesdits seconds miroirs de courant recevant ledit courant d'entrée de la chaîne d'amplification et le copiant afin de le transmettre auxdits premiers miroirs de courant dudit premier étage de polarisation d'une part, deux desdits transistors constituant lesdits seconds miroirs de courant étant transformés en une paire différentielle de transistors de sortie d'autre part, lorsque ledit étage complémentaire d'amplification est activé ;
- des moyens d'activation dudit étage complémentaire d'amplification en fonction de la fréquence du courant d'entrée de la chaîne d'amplification, ledit étage comlémentaire d'amplification étant activé en hautes fréquences et désactivé en basses fréquences;
- un second étage de polarisation comprenant notamment :
   * au moins deux troisièmes miroirs de courant constitués chacun de deux transistors et permettant, lorsque ledit second étage de polarisation n'est pas désactivé, une polarisation de la ou des paires différentielles de transistors de sortie dudit second multiplieur translinéaire ;
   * au moins deux quatrièmes miroirs de courant constitués chacun de deux transistors, lesdits quatrièmes miroirs de courant recevant ledit courant d'entrée de la chaîne d'amplification et le copiant afin de le transmettre auxdits premiers miroirs de courant dudit premier étage de polarisation lorsque ledit second étage de polarisation n'est pas désactivé ; et
- des moyens de désactivation dudit second étage de polarisation en fonction de la fréquence du courant d'entrée de la chaîne d'amplification, ledit second étage de polarisation étant désactivé en hautes fréquences et activé en basses fréquences.

En d'autres termes, deux des modules élémentaires constituant les moyens d'amplification de la première cellule de gain reçoivent le courant d'entrée de la chaîne d'amplification, à savoir d'une part l'étage complémentaire d'amplification (qui travaille en hautes fréquences) et d'autre part le second étage de polarisation (qui travaille en basses fréquences), les moyens d'activation et les moyens de désactivation garantissant que seul l'un de ces deux modules peut être actif à la fois.

Par ailleurs, quel que soit le module activé, celui-ci copie le courant d'entrée de la chaîne d'amplification afin de le transmettre au premier étage de polarisation.

Ainsi, un étage de polarisation est associé à chacun des multiplieurs. La polarisation ainsi réalisée pour la première cellule de gain peut être automatique (on parle également d'autopolarisation) puisque le courant d'entrée de cellule contient le courant de polarisation (généralement noté Iₒ), qui est alors le courant de mode commun.

Dans ce cas d'une autopolarisation, le courant d'entrée de la première cellule de gain comprend un courant continu de polarisation et on obtient une première cellule de gain telle que les sources de courant des deux multiplieurs sont autopolarisées. En effet, le courant continu de polarisation est alors un courant de mode commun et est utilisé par les miroirs de courant de chacun des étages de polarisation pour produire la polarisation des transistors de la paire différentielle du multiplieur correspondant : les premier et second multiplieurs sont autopolarisés grâce respectivement au premier et au second étages de polarisation.

Par ailleurs, le gain est fixé uniquement par le rapport des transistors constituant les deux étages de polarisation. En d'autres termes, ces étages de polarisation confèrent aux moyens d'amplification une excellente réjection de mode commun. Par conséquent, l'autopolarisation, si elle est envisagée, n'est possible que pour la première cellule de gain puisque les cellules de gain suivantes ne reçoivent pas de courant de mode commun.

De plus, les miroirs des étages de polarisation ne sont pas liés à la composante différentielle du courant puisqu'ils apparaissent à celle-ci comme une masse virtuelle. Par conséquent, on peut utiliser, pour réaliser ces étages de polarisation, de gros transistors présentant un offset limité et un bruit réduit.

Enfin, l'utilisation de miroirs de courant dans ces étages de polarisation permet de garantir que l'on a un même courant de polarisation dans les deux multiplieurs de la cellule. Cette condition garantit qu'il n'y a pas de courant de mode commun en sortie.

L'ensemble formé des premier et second étages de polarisation, de l'étage complémentaire d'amplification, des moyens d'activation et des moyens xde désactivation permet d'améliorer la rapidité des moyens d'amplification d'une cellule de gain. En effet, le second étage de polarisation est lent (il est destiné à ne travailler qu'en basses fréquences) et peut donc être réalisé avec des gros transistors qui permettent de réduire l'offset de courant. Par contre, l'étage complémentaire d'amplification, qui est cascodé au second étage de polarisation, est rapide (il est destiné à ne travailler qu'en hautes fréquences) et doit être réalisé avec des petits transistors.

Avantageusement, lesdits moyens d'amplification de ladite seconde cellule de gain comprennent :
- un premier étage de polarisation comprenant notamment au moins deux premiers miroirs de courant constitués chacun de deux transistors et permettant une polarisation de la ou des paires différentielles de transistors de sortie dudit premier multiplieur translinéaire et constituant une masse virtuelle pour les transistors d'entrée dudit premier multiplieur translinéaire ;
- un étage complémentaire d'amplification comprenant au moins deux transistors reliés chacun à un des transistors desdits seconds miroirs de courant de ladite première cellule de gain de façon à constituer au moins deux cinquièmes miroirs de courant, lesdits cinquièmes miroirs de courant recevant ledit courant d'entrée de la chaîne d'amplification et le copiant afin de le transmettre auxdits premiers miroirs de courant dudit premier étage de polarisation de la seconde cellule de gain d'une part, lesdits transistors de l'étage complémentaire d'amplification étant transformés en une paire différentielle de transistors de sortie d'autre part, lorsque ledit étage complémentaire d'amplification est activé;
- des moyens d'activation dudit étage complémentaire d'amplification en fonction de la fréquence du courant d'entrée de la chaîne d'amplification, ledit étage comlémentaire d'amplification étant activé en hautes fréquences et désactivé en basses fréquences;
- un second étage de polarisation comprenant notamment :
   * au moins deux transistors reliés chacun à un des transistors desdits troisièmes miroirs de courant de ladite première cellule de gain de façon à constituer au moins deux sixièmes miroirs de courant permettant, lorsque le second étage de polarisation de la première cellule de gain n'est pas désactivé, une polarisation de la ou des paires différentielles de transistors de sortie dudit second multiplieur translinéaire de la seconde cellule de gain ;
   * au moins deux transistors reliés chacun à un des transistors desdits quatrièmes miroirs de courant de ladite première cellule de gain de façon à constituer au moins deux septièmes miroirs de courant recevant ledit courant d'entrée de la chaîne d'amplification et le copiant afin de le transmettre auxdits premiers miroirs de courant dudit premier étage de polarisation de la seconde cellule de gain, lorsque le second étage de polarisation de la première cellule de gain n'est pas désactivé,
   lesdites première et seconde entrées des moyens d'amplification de ladite seconde cellule de gain étant situées au niveau respectivement dudit second multiplieur translinéaire et dudit étage complémentaire d'amplification, lesdits moyens d'activation de l'étage complémentaire d'amplification de la seconde cellule de gain constituant lesdits moyens d'activation/désactivation de la seconde entrée des moyens d'amplification de ladite seconde cellule de gain.

Ainsi, contrairement à la première cellule de gain qui reçoit un seul type de courant à amplifier (à savoir le courant d'entrée de la chaîne d'amplification, qui comprend le courant continu de polarisation), ce courant étant reçu au niveau du second étage de polarisation et de l'étage complémentaire d'amplification, les secondes cellules de gain reçoivent deux types de courant à amplifier, à savoir :
- d'une part, au niveau du second multiplieur, le courant amplifié et filtré de sortie de la cellule précédente (courant "basse fréquence"), et
- d'autre part, au niveau de l'étage complémentaire d'amplification (lorsqu'il est activé), le courant d'entrée de la chaîne d'amplification (courant "haute fréquence") permettant de compenser la rotation de phase induite par la cellule de gain précédente.

Il est à noter que les secondes cellules de gain ne sont pas autopolarisées mais sont polarisées par l'intermédiaire de leur second étage de polarisation qui est relié au second étage de polarisation de la première cellule de gain.

Avantageusement, lesdits moyens de filtrage passe-bas de chacune desdites première et seconde cellules de gain comprennent deux couples d'éléments passifs constitués chacun d'une résistance et un condensateur.

De façon avantageuse, les moyens d'activation de l'étage complémentaire d'amplification de la première cellule de gain, les moyens de désactivation du second étage de polarisation de la première cellule de gain, et les moyens d'activation de l'étage complémentaire d'amplification de la seconde cellule de gain sont constitués d'au moins un condensateur se comportant comme un court-circuit en hautes fréquences.

De façon avantageuse, lesdits transistors appartiennent au groupe comprenant les transistors bipolaires et les transistors MOS.

L'invention n'est donc pas limitée à un type particulier de transistors.

Ainsi, dans un mode de réalisation avantageux de l'invention, les transistors sont du type MOS et pour chacune des cellules de gain :
- les transistors mis en oeuvre dans le premier multiplieur translinéaire et le premier étage de polarisation sont du type PMOS, et
- les transistors mis en oeuvre dans le second multiplieur translinéaire, l'étage complémentaire d'amplification et le second étage de polarisation sont du type NMOS.

Dans un autre mode de réalisation avantageux de l'invention, les transistors sont du type bipolaire et pour chacune des cellules de gain:
- les transistors mis en oeuvre dans le premier multiplieur translinéaire et le premier étage de polarisation sont du type PNP, et
- les transistors mis en oeuvre dans le second multiplieur translinéaire, l'étage complémentaire d'amplification et le second étage de polarisation sont du type NPN.

L'invention concerne également un amplificateur opérationnel intégrant une chaîne d'amplification en mode de courant selon l'invention.

Enfin, l'invention propose des solutions avantageuses pour la réalisations de certains sous-ensembles de la chaîne d'amplification.

Ainsi, l'invention concerne une cellule de gain destinée à être mise en oeuvre dans une chaîne d'amplification en mode de courant selon l'invention, cette cellule de gain comprenant des moyens d'amplification constituées notamment de deux multiplieurs translinéaires symétriques l'un par rapport à l'autre et combinés de façon que les sorties desdits multiplieurs translinéaires soient communes et constituent la sortie desdits moyens d'amplification.

D'autres caractéristiques et avantages de l'invention apparaîtront à la lecture de la description suivante d'un mode de réalisation préférentiel de l'invention, donné à titre d'exemple indicatif et non limitatif, et des dessins annexés, dans lesquels :
- la figure 1 présente un schéma logique simplifié d'un mode de réalisation particulier d'une chaîne d'amplification en mode de courant selon l'invention;
- la figure 2A présente un schéma simplifié logique de la première cellule de gain d'une chaîne d'amplification selon l'invention telle que présentée sur la figure 1 ;
- la figure 2B présente un schéma simplifié logique d'une seconde cellule de gain d'une chaîne d'amplification selon l'invention telle que présentée sur la figure 1 ;
- la figure 2C présente un schéma électrique d'un exemple de mode de réalisation des moyens de filtrage des première et seconde cellules de gain telles que présentées sur les figures 2A et 2B respectivement ;
- la figure 3 présente une courbe de variation du gain en fonction de la fréquence pour une chaîne d'amplification selon l'invention telle que présentée sur la figure 1 ;
- la figure 4 présente une courbe de variation de la phase en fonction de la fréquence pour une chaîne d'amplification selon l'invention telle que présentée sur la figure 1 ;
- les figures 5A et 5B présentent chacune un schéma électrique, à base de transistors bipolaires et MOS respectivement, d'une combinaison entre deux multiplieurs translinéaires symétriques, une telle combinaison pouvant être mise en oeuvre dans les moyens d'amplification desdites première et seconde cellules de gain d'une chaîne d'amplification selon l'invention telle que présentée sur la figure 1 ;
- la figure 6 présente un schéma électrique des moyens d'amplification de la première cellule de gain de la chaîne d'amplification de la figure 1 ; et
- la figure 7 présente un schéma électrique des moyens d'amplification d'une des secondes cellules de gain de la chaîne d'amplification de la figure 1.

L'invention concerne donc une chaîne d'amplification en mode de courant. Selon l'invention, cette chaîne peut être intégrée dans un amplificateur opérationnel. Par souci de simplification, on parlera par la suite uniquement d'amplificateur opérationnel. Il est clair toutefois, que l'invention n'est pas limitée à ce mode de réalisation particulier mais concerne plus généralement une chaîne d'amplification dont les éléments constitutifs peuvent être ou non intégrés dans un même boîtier.

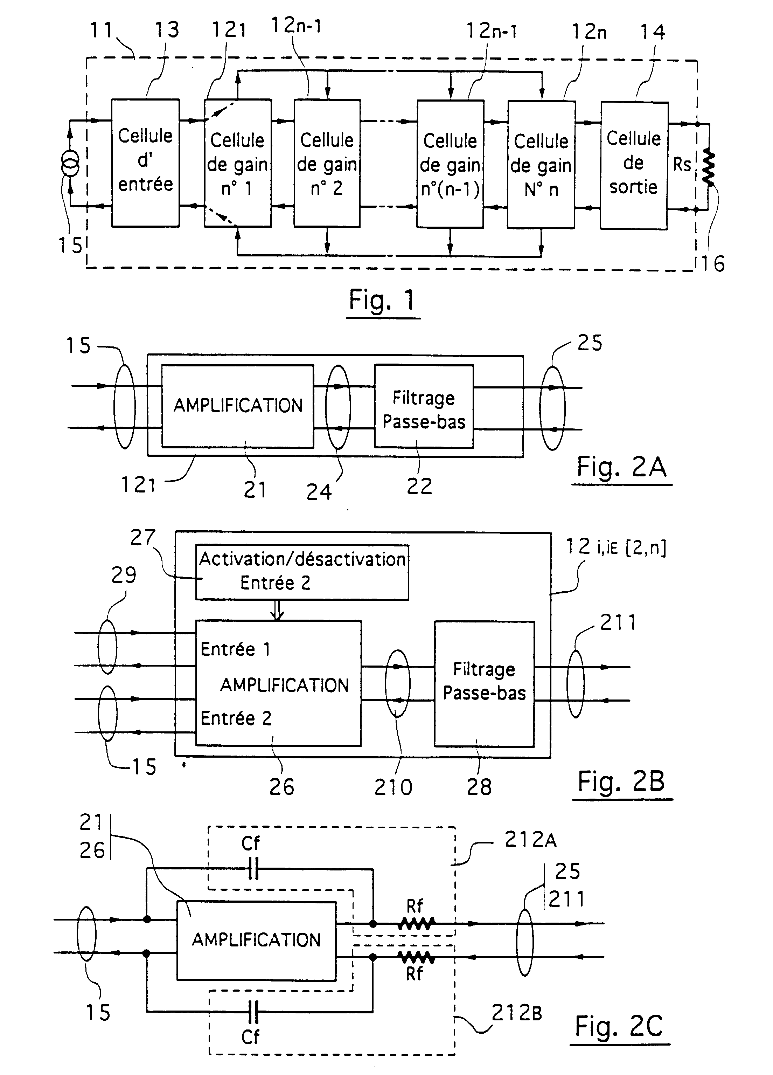

La figure 1 présente un schéma logique simplifié d'un mode de réalisation particulier d'un tel amplificateur selon l'invention.

Dans ce mode de réalisation particulier de l'invention, l'amplificateur opérationnel en mode de courant 11 comprend une première cellule de gain 12₁ et n-1 secondes cellules de gain 12₂ à 12ₙ montées en cascade. La première cellule de gain 12₁ reçoit le courant d'entrée 15 d'amplificateur opérationnel. Chaque seconde cellule de gain 12₂ à 12ₙ reçoit d'une part le courant de sortie de la cellule de gain précédente et d'autre part le courant d'entrée 15 d'amplificateur opérationnel.

Le principe de l'invention consiste à hiérarchiser ces cellules de gain en les cascadant selon un ordre croissant de rapidité et à réinjecter le courant d'entrée d'amplificateur 15 dans chacune des secondes cellules de gain 12₂ à 12ₙ afin de compenser la rotation de phase induite par la cellule de gain précédente.

Dans ce mode de réalisation particulier de l'invention, l'amplificateur opérationnel comprend également une cellule d'entrée 13 et une cellule de sortie 14 réalisant une adaptation d'impédance en entrée et en sortie respectivement.

La cellule d'entrée 13 est placée en amont de la cascade de cellules de gain 12₁ à 12ₙ et reçoit le courant d'entrée d'amplificateur. Elle possède une très faible impédance d'entrée et délivre un courant égal à la somme du courant d'entrée 15 d'amplificateur d'une part et d'un courant continu de polarisation Iₒ d'autre part.

La cellule de sortie 14 est placée en aval de la cascade de cellules de gain 12₁ à 12ₙ et reçoit le courant de sortie de la dernière cellule de gain 12ₙ Cette cellule de sortie 14 possède une très forte impédance de sortie et délivre le courant de sortie 16 à la charge de sortie Rₛ.

La figure 2A présente un schéma simplifié logique de la première cellule de gain de la chaîne d'amplification en mode de courant selon l'invention telle que présentée sur la figure 1. Cette première cellule de gain 12₁ comprend :
- des moyens d'amplification 21 recevant le courant d'entrée 15 de la chaîne d'amplification 11 et délivrant un courant amplifié de sortie 24 ;
- des moyens de filtrage passe-bas 22 recevant le courant amplifié 24 de sortie des moyens d'amplification 21 de cette première cellule de gain 12₁, et délivrant un courant de sortie amplifié et filtré 25 (QUI est le courant de sortie de cette première cellule de gain).

La figure 2B présente un schéma simplifié logique d'une des secondes cellules de gain 12₂ à 12ₙ de la chaîne d'amplification en mode de courant selon l'invention telle que présentée sur la figure 1. Chacune de ces secondes cellules de gain 12₂ à 12ₙ comprend :
- des moyens d'amplification 26 comportant d'une part une première entrée (notée ENTREE 1) recevant le courant de sortie amplifié et filtré 29 de la cellule de gain précédente dans ladite cascade et d'autre part une seconde entrée (notée ENTREE 2) recevant le courant d'entrée 15 de la chaîne d'amplification 11, et délivrant un courant amplifié de sortie 210 ;
- des moyens d'activation/désactivation 27 de la seconde entrée ENTREE 2 ;
- des moyens de filtrage passe-bas 28 recevant le courant amplifié 210 de sortie des moyens d'amplification 26 de cette seconde cellule de gain, et délivrant un courant de sortie amplifié et filtré 211.

Les moyens de filtrage passe-bas 22, 28 de chacune des cellules de gain 12₁ à 12ₙ montées en cascade possèdent une fréquence de coupure haute (f_{h,i}), où i est le numéro de la cellule de gain dans la cascade. Ces moyens de filtrage passe-bas créent un pôle dominant au niveau de la cellule de gain à laquelle ils appartiennent, ce pôle dominant ramenant le gain de la cellule en dessous de 0 dB.

Les cellules de gain 12₁ à 12ₙ sont hiérarchisées de façon que les fréquences de coupure hautes f_{h,1} à f_{h,n} soient dans un ordre croissant. En d'autres termes, les cellules de gain sont de plus en plus rapides quand on s'éloigne de l'entrée de l'amplificateur opérationnel 11.

La figure 2C présente un schéma électrique d'un exemple de mode de réalisation des moyens de filtrage 22, 28 des première 12₁ et secondes 12₂ à 12ₙ cellules de gain telles que présentées sur les figures 2A et 2B respectivement. Dans un souci de simplification, la deuxième entrée de courant (dans le cas d'une seconde cellule de gain) n'a pas été représentée. Dans ce mode de réalisation, les les moyens de filtrage passe-bas 22, 28 comprennent deux couples 212_{A} et 212_{B} d'éléments passifs constitués chacun d'une résistance R_{f} et d'un condensateur C_{f}.

Les moyens 27 d'activation/désactivation de la seconde entrée ENTREE 2 des moyens d'amplification 26 de chaque seconde cellule de gain 12₂ à 12ₙ sont du type passe-haut et possèdent une fréquence de coupure basse f_{b,i}, où i est le numéro de la seconde cellule de gain dans la cascade. La seconde entrée ENTREE 2 des moyens d'amplification d'une seconde cellule de gain 12ᵢ est activée pour les fréquences supérieures à la fréquence de coupure basse f_{b,i} de cette seconde cellule de gain, et désactivée pour les autres fréquences. L'ordre des fréquences de coupures basses f_{b,2} à f_{b,n}, donné par l'ordre de cascade des secondes cellules de gain 12₂ à 12ₙ, est croissant.

Dans la suite de la description, on considère le cas particulier avantageux où la fréquence de coupure basse f_{b,i+1} des moyens d'activation/désactivation 27 de la seconde entrée ENTREE 2 d'une seconde cellule de gain 12ᵢ₊₁ est sensiblement inférieure à la fréquence de coupure haute (f_{h,i}) des moyens de filtrage passe-bas 22, 28 de la cellule de gain précédente 12ᵢ (première ou seconde cellule de gain).

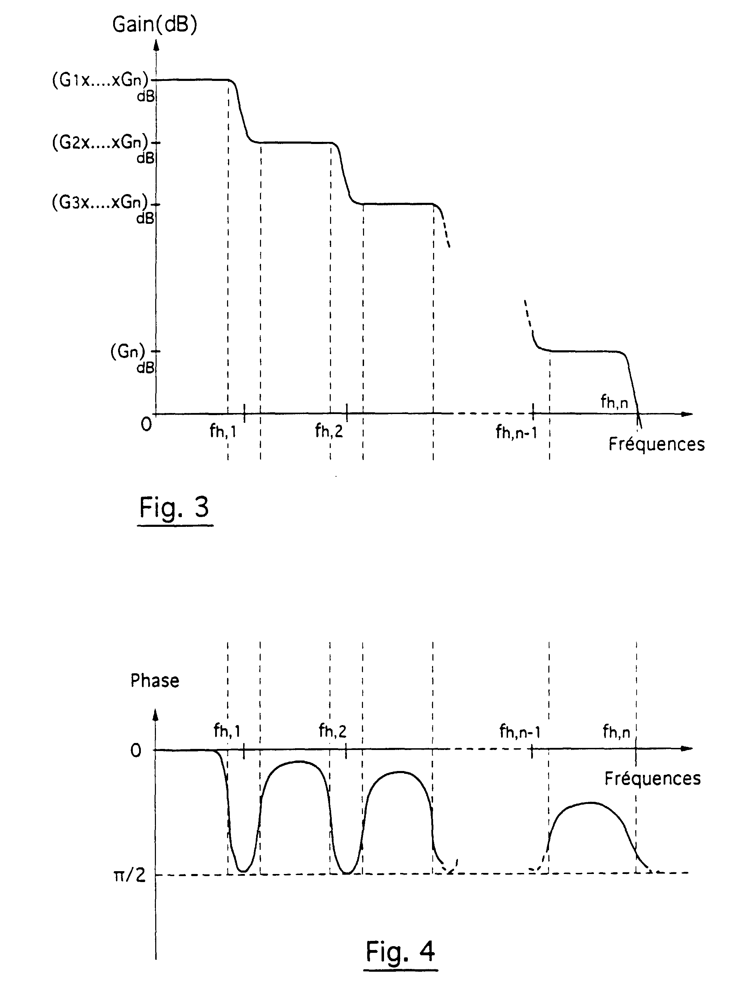

Le principe de l'invention va maintenant être décrit en détail, en relation avec les figures 3 et 4 qui présentent chacune une courbe de variation, respectivement du gain et de la phase, en fonction de la fréquence pour un amplificateur opérationnel selon l'invention tel que présenté sur la figure 1.

En basse fréquence, c'est-à-dire de 0 Hz jusqu'à la fréquence de coupure haute f_{h,1} des moyens de filtrage passe-bas de la première cellule de gain 12₁, le courant d'entrée 15 de l'amplificateur opérationnel 11 est amplifié successivement par chacune des n cellules de gain 12₁ à 12ₙ mises en cascade. En notant Gᵢ le gain de la i^{ème} cellule de gain, le gain total dans cete bande de fréquences [0, f_{h,1}] est donc sensiblement constant et tel que G = G₁ x G₂ x G₃ x...x Gₙ.

Aux alentours de la fréquence de coupure haute f_{h,1} des moyens de filtrage passe-bas de la première cellule de gain 12₁, le gain de cette première cellule de gain diminue jusqu'à s'annuler.

Par conséquent, pour les fréquences supérieurs à f_{h,1}, la première cellule de gain n'a aucune influence sur le gain total.

En ce qui concerne la phase, la première cellule de gain 12₁ induit, à partir d'une fréquence sensiblement égale à la fréquence de coupure haute f_{h,1} de ses moyens de filtrage passe-bas, une rotation de phase de π/2.

Selon l'invention, cette rotation de phase est compensée, dans la seconde cellule de gain suivante 12₂, par le courant d'entrée 15 que l'on injecte dans la seconde entrée ENTREE 2 des moyens d'amplification 26 de cette seconde cellule de gain 12₂. En effet, pour des fréquences supérieures à la fréquence de coupure haute f_{h,1} des moyens de filtrage passe-bas de la première cellule (et donc également supérieures à la fréquence de coupure basse des moyens d'activation/désactivation de la seconde cellule de gain suivante 12₂), le courant amplifié par cette seconde cellule de gain 12₂ est essentiellement constitué du courant injecté qui ne présente aucune rotation de phase. Le courant de sortie de cellule ainsi obtenu est large bande puisque le courant amplifié et filtré 25 de sortie de la première cellule et le courant injecté dans la seconde cellule se situent dans les bandes de fréquences [o,f_{h,1}] et ]f_{b,1}, ∞[ respectivement.

En reprenant le même raisonnement que précedemment, on comprend aisément qu'entre la fréquence de coupure haute f_{h,1} des moyens de filtrage passe-bas de la première cellule de gain 12₁ et la fréquence de coupure haute f_{h,2} des moyens de filtrage passe-bas de la seconde cellule de gain 12₂, le gain total de l'amplificateur est : G = G2 x G3 x...x Gn. De même, la phase qui subit une rotation de π/2 aux alentours de f_{h,2}, est ramenée à une valeur acceptable grâce à la compensation réalisée par l'injection du courant d'entrée filtré, dans la seconde entrée des moyens d'amplification de la troisième cellule de gain 12₂.

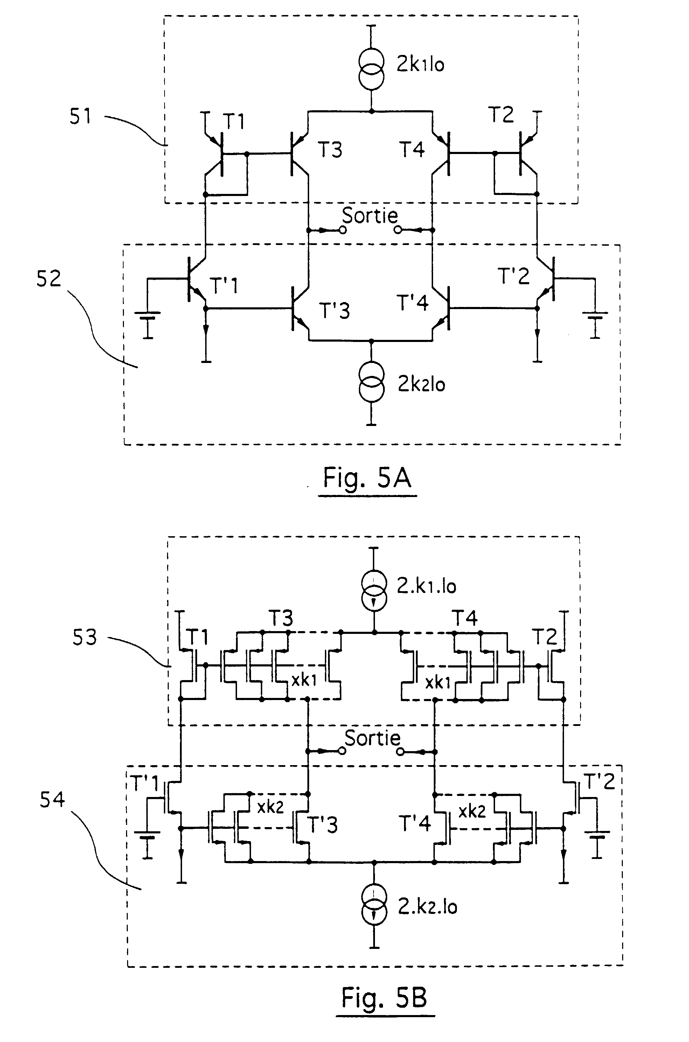

Les moyens d'amplification 21, 26 d'une cellules de gain 12₁ à 12ₙ sont maintenant étudiés en détail en relation avec les figures 5A, 5B, 6 et 7.

La figure 5A présente un schéma électrique (à base de transistors bipolaires) d'une combinaison entre deux multiplieurs translinéaires symétriques, cette combinaison pouvant être mise en oeuvre dans les moyens d'amplification 21, 26 d'une cellule de gain 12₁ à 12ₙ selon l'invention telle que présentée sur la figure 1.

Dans l'état de la technique, une cellule de gain comprend généralement un multiplieur translinéaire qui exploite la caractéristique exponentielle de la jonction PN. On connaît plusieurs types de multiplieurs translinéaires (pouvant être réalisés aussi bien en bipolaire qu'en MOS). Selon l'invention, on combine deux types de multiplieurs translinéaires présentant la particularité d'être symétriques l'un par rapport à l'autre.

Ainsi, les moyens d'amplification d'un cellule de gain comprennent un premier 51 et un second 52 multiplieurs translinéaires symétriques l'un par rapport à l'autre et combinés de façon que les sorties soient communes et constituent la sortie des moyens d'amplification.

Chacun des multiplieurs 51, 52 comprend deux transistors d'entrée T1,T2 et T'1, T'2 et une paire différentielle de transistors de sortie T3,T4 et T'3,T'4.

On note k₁ le facteur multiplicatif du premier multiplicateur 51 et k₂ celui du second 52. En choisissant k₁ = k₂, on double le gain par rapport à un muliplieur seul, tout en conservant une même consommation.

Le courant de polarisation Iₒ est soit contenu dans le courant d'entrée de cellule, soit amené indépendamment de celui-ci. Le premier cas n'est possible que pour la première cellule de gain puisque celle-ci reçoit le courant issu de l'étage d'entrée et contenant le courant de polarisation Iₒ, mais supprime la composante continue de mode commun (et donc le courant de polarisation).

Dans ce mode de réalisation à base de transistors bipolaires, le premier multiplieur 51 est réalisé avec des transistors PNP alors que le second multiplieur est réalisé avec des transistors NPN.

La figure 5B correspond à la version MOS du schéma électrique à base de transistors bipolaires présenté sur la figure 5A. La passage du bipolaire au MOS implique un changement de mode de calcul puisqu'on passe à une caractéristique quadratique. Toutefois, mises à part de très légères modifications (notamment une pluralité de paires différentielles T3,T4 et T'3,T'4 de transistors de sortie au lieu d'une seule paire), les schémas électriques présentent des structures très proches.

Dans le mode de réalisation présenté sur la figure 5B, le premier multiplieur 53 est réalisé avec des transistors PMOS et le second multiplieur 54 est réalisé avec des transistors NMOS.

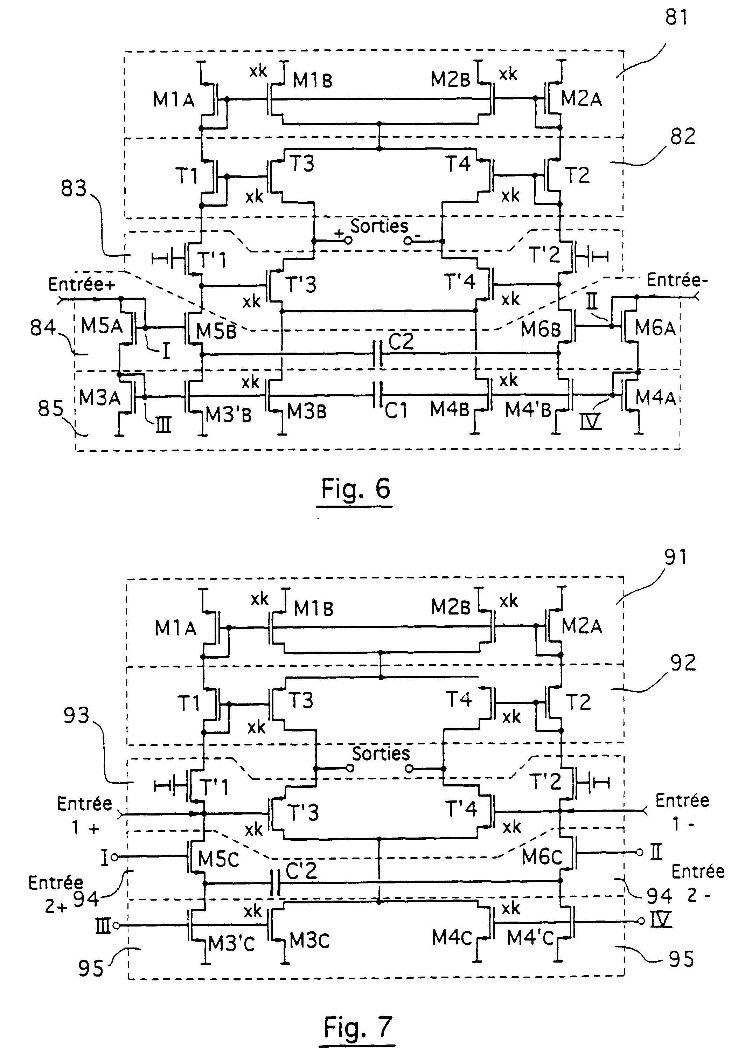

La figure 6 présente un schéma électrique d'un mode de réalisation des moyens d'amplification 21 de la première cellule de gain 12₁ de la chaîne d'amplification de la figure 1. Selon ce mode de réalisation particulier, les moyens d'amplification de la première cellule de gain 12₁ comprennent :
- un premier multiplieur 82 coopérant avec un premier étage de polarisation 81 ;
- un second multiplieur 83 coopérant avec un second étage de polarisation 85 et un étage complémentaire d'amplification 84 ;
- des moyens d'activation C2 de l'étage complémentaire d'amplification 84 ; et
- des moyens de désactivation C1 du second étage de polarisation 85.

Le premier étage de polarisation 81 comprend k premiers miroirs de courant (M1_{A}, M1_{B}) et (M2_{A}, M2_{B})) constitués chacun de deux transistors et permettant une polarisation des k paires différentielles de transistors de sortie T3, T4 du premier multiplieur translinéaire 82 et constituant une masse virtuelle pour les transistors d'entrée T1, T2 du premier multiplieur translinéaire 82.

L'étage complémentaire d'amplification 84 comprend deux seconds miroirs de courant (M5_{A}, M5_{B}), (M6_{A}, M6_{B}), constitués chacun de deux transistors. Lorsque l'étage complémentaire d'amplification 84 est activé, ces seconds miroirs de courant reçoivent (ENTREE+ et ENTREE-) le courant d'entrée de la chaîne d'amplification et le copient afin de le transmettre aux premiers miroirs de courant du premier étage de polarisation. De plus, deux des transistors constituant les seconds miroirs de courant sont alors transformés en une paire différentielle de transistors de sortie M5_{B}, M6_{B}.

Les moyens d'activation C2 de l'étage complémentaire d'amplification 84 sont tels que l'étage comlémentaire d'amplification est activé en hautes fréquences et désactivé en basses fréquences.

Le second étage de polarisation 85 comprend notamment:
* k troisièmes miroirs de courant (M3_{A}, M3_{B}), (M4_{A}, M4_{B}) constitués chacun de deux transistors et permettant, lorsque le second étage de polarisation n'est pas désactivé, une polarisation des k paires différentielles de transistors de sortie T3', T4' du second multiplieur translinéaire 83 ;
* deux quatrièmes miroirs de courant (M3_{A}, M3_{B}', (M4_{A}, M4_{B}') constitués chacun de deux transistors. Lorsque le second étage de polarisation 85 n'est pas désactivé, ces quatrièmes miroirs de courant reçoivent (par l'intermédiaire d'ENTREE+ et ENTREE-) le courant d'entrée de la chaîne d'amplification et le copient afin de le transmettre aux premiers miroirs de courant du premier étage de polarisation 81.

Les moyens de désactivation C1 du second étage de polarisation 85 sont tels que le second étage de polarisation est désactivé en hautes fréquences et activé en basses fréquences.

Ces moyens d'activation C2 et de désactivation C1 sont constitués de condensateurs se comportant comme un court-circuit en hautes fréquences. Ainsi, le second étage de polarisation 85 constitué de transistors lents donc pouvant être gros, est utilisé (cascodé à l'étage complémentaire d'amplification 84) en basses fréquences, où il permet de limiter l'offset de courant et le bruit. Pour les fréquences plus élevées, seul l'étage complémentaire d'amplification 84, constitués de transistors rapides, est utilisé.

Les transistors sont du type :
- PMOS pour le premier multiplieur translinéaire 82 et le premier étage de polarisation 81, et
- NMOS pour le second multiplieur translinéaire 83, le second étages de polarisation 85 et l'étage complémentaire d'amplification 84.

Pour cette première cellule de gain 12₁, les composantes du courant d'entrée, qui contiennent le courant de polarisation Iₒ, sont injectées directement dans les miroirs de courant de l'étage complémentaire d'amplification 84 et, du fait de la structure cascodée, indirectement dans les miroirs de courant du second étage de polarisation 85.

Ainsi, on garantit qu'on a bien le même courant de polarisation Iₒ dans les deux multiplieurs 82, 83. Ceci assure que les moyens d'amplification de cette première cellule de gain n'injectent pas de courant de mode commun en sortie. De plus, tous les transistors de polarisation ont une même tension drain-source (ou collecteur-émetteur), ce qui améliore l'appariement des transistors.

Il est clair que la version bipolaire non représentée correspondant à cette version MOS peut être réalisée.

La figure 7 présente un schéma électrique d'un mode de réalisation des moyens d'amplification 26 de chacune des secondes cellules de gain 12₂ à 12ₙ de la chaîne d'amplification de la figure 1. Selon ce mode de réalisation particulier, les moyens d'amplification d'une seconde cellule de gain 12₂ à 12ₙ possèdent une structure assez proche de celle des moyens d'amplification de la première cellule de gain 12₁ et comprennent :
- un premier multiplieur 92 coopérant avec un premier étage de polarisation 91 ;
- un second multiplieur 93 coopérant avec un second étage de polarisation 95 et un étage complémentaire d'amplification 94 ;
- des moyens d'activation C'2 de l'étage complémentaire d'amplification 94.

Le premier étage de polarisation 91 est identique à celui 81 des moyens d'amplification de la première cellule de gain.

L'étage complémentaire d'amplification 94 comprend deux transistors M5_{C}, M6_{C} reliés chacun (au niveau des points référencés I et II sur les figures 6 et 7) à un des transistors M5_{A}, M6_{A} des seconds miroirs de courant (M5_{A}, M5_{B}), (M6_{A}, M6_{B}) de la première cellule de gain de façon à constituer deux cinquièmes miroirs de courant (M5_{A}, M5_{C}), (M6_{A}, M6_{C}). Lorsque cet étage complémentaire d'amplification 94 est activé, les cinquièmes miroirs de courant reçoivent le courant d'entrée 15 de la chaîne d'amplification et le copient afin de le transmettre aux premiers miroirs de courant du premier étage de polarisation 91 de la seconde cellule de gain. De plus, les transistors de l'étage complémentaire d'amplification 94 sont alors transformés en une paire différentielle de transistors de sortie (M5_{C}, M6_{C}).

Les moyens d'activation C2' de l'étage complémentaire d'amplification 94 sont tels que l'étage complémentaire d'amplification 94 est activé en hautes fréquences et désactivé en basses fréquences. Le second étage de polarisation 95 comprend notamment :
* k paires de transistors M3_{C} M4_{C} reliés chacun (au niveau des points référencés III et IV sur les figures 6 et 7) à un des transistors M3_{A}, M4_{A} des troisièmes miroirs de courant (M3_{A}, M3_{B}), (M4_{A}, M4_{B}) de la première cellule de gain de façon à constituer deux sixièmes miroirs de courant (M3_{A},M3_{C}),(M4_{A},M4_{C}). Lorsque le second étage de polarisation 85 de la première cellule de gain n'est pas désactivé, ces sixièmes miroirs de courant permettent une polarisation de la ou des paires différentielles de transistors de sortie T3', T4' du second multiplieur translinéaire 93 de la seconde cellule de gain ;
* deux transistors M3_{C}', M4_{C}' reliés chacun à un des transistors M3_{A}, M4_{A} des quatrièmes miroirs de courant (M3_{A}, M3_{B}'), (M4_{A}, M4_{B}') de la première cellule de gain de façon à constituer deux septièmes miroirs de courant. Lorsque le second étage de polarisation 85 de la première cellule de gain n'est pas désactivé, ces septièmes miroirs de courant reçoivent le courant d'entrée de la chaîne d'amplification et le copient afin de le transmettre aux premiers miroirs de courant du premier étage de polarisation de la seconde cellule de gain.

Les première (ENTREE1+, ENTREE1-) et seconde (ENTREE2+, ENTREE2-) entrées des moyens d'amplification de la seconde cellule de gain sont situées au niveau respectivement du second multiplieur translinéaire 93 et de l'étage complémentaire d'amplification 94. Les moyens d'activation C2' de l'étage complémentaire d'amplification 94 de la seconde cellule de gain constituent les moyens d'activation/désactivation de la seconde entrée des moyens d'amplification de la seconde cellule de gain.

Comme précédemment, le second étage de polarisation 95 est plus lent que l'étage complémentaire d'amplification 94.

Pour ces secondes cellules de gain 12₂ à 12ₙ (c'est-à-dire les cellules de gain autres que la première 12₁), les composantes du courant de sortie de la cellule gain précédente ne contiennent pas de courant de polarisation Iₒ du fait de la bonne réjection de mode commun de la première cellule de gain 12₁.

## Revendications

1. Chaîne d'amplification en mode de courant (11), caractérisée en ce qu'elle comprend une première cellule de gain (12₁) et au moins une seconde cellule de gain (12₂ à 12ₙ) montées en cascade,
ladite première cellule de gain (12₁) comprenant :
- des moyens d'amplification (21) recevant un courant d'entrée (15) de ladite chaîne d'amplification (11) et délivrant un courant amplifié de sortie (24) ;
- des moyens de filtrage passe-bas (22) recevant ledit courant amplifié de sortie (24) desdits moyens d'amplification (21) de ladite première cellule de gain, et délivrant un courant de sortie amplifié et filtré (25) ;
ladite seconde cellule de gain (12₂ à 12ₙ) comprenant :
- des moyens d'amplification (26) comportant d'une part une première entrée (ENTREE 1) recevant le courant de sortie amplifié et filtré (25 ; 211) de la cellule de gain précédente dans ladite cascade et d'autre part une seconde entrée (ENTREE 2) recevant le courant d'entrée (15) de ladite chaîne d'amplification, et délivrant un courant amplifié de sortie (210) ;
- des moyens d'activation/désactivation (27) de ladite seconde entrée (ENTREE 2) ;
- des moyens de filtrage passe-bas (28) recevant ledit courant amplifié (210) de sortie desdits moyens d'amplification (26) de ladite seconde cellule de gain, et délivrant un courant de sortie amplifié et filtré (211),
et en ce que lesdits moyens de filtrage passe-bas (28) de chacune desdites cellules de gain montées en cascade possèdent une fréquence de coupure haute (f_{h,i}), l'ordre croissant des fréquences de coupure hautes correspondant à l'ordre de cascade des cellules de gain (12₁ à 12ₙ), de l'entrée vers la sortie de ladite chaîne d'amplification (11).

2. Chaîne d'amplification selon la revendication 1, caractérisée en ce que lesdits moyens d'activation/désactivation (27) de la seconde entrée des moyens d'amplification de ladite seconde cellule de gain sont du type passe-haut et possèdent une fréquence de coupure basse, ladite seconde entrée étant activée pour les fréquences supérieures à ladite fréquence de coupure basse et désactivée pour les autres fréquences, l'ordre croissant desdites fréquences de coupure basses correspondant audit ordre de cascade des cellules de gain, de l'entrée vers la sortie de ladite chaîne d'amplification (11).

3. Chaîne d'amplification selon la revendication 2, caractérisée en ce que la fréquence ce coupure basse des moyens d'activation/désactivation (27) de ladite seconde entrée de la seconde cellule de gain est sensiblement inférieure à la fréquence de coupure haute (f_{h,i}) des moyens de filtrage passe-bas (22 ; 28) de la cellule de gain précédente.

4. Chaîne d'amplification selon l'une quelconque des revendications 1 à 3, caractérisée en ce qu'elle comprend une cellule d'entrée (13), placée en amont de ladite cascade de cellules de gain (12₁ à 12ₙ) et recevant ledit courant d'entrée de la chaîne d'amplification, ladite cellule d'entrée (13) possédant une très faible impédance d'entrée,
et en ce que ladite cellule d'entrée (13) comprend des moyens d'addition et délivre un courant égal à la somme du courant d'entrée de chaîne d'amplification (11) et d'un courant continu de polarisation (Iₒ).

5. Chaîne d'amplification selon l'une quelconque des revendications de 1 à 4, caractérisée en ce qu'elle comprend une cellule de sortie (14), placée en aval de ladite cascade de cellules de gain (12₁ à 12ₙ) et recevant le courant de sortie de la dernière cellule de gain (12ₙ), ladite cellule de sortie (14) possédant une très forte impédance de sortie.

6. Chaîne d'amplification selon l'une quelconque des revendications de 1 à 5, caractérisée en ce que lesdits moyens d'amplification (21 ; 26) de chacune desdites première et seconde cellules de gain comprennent un premier et un second multiplieurs translinéaires (51, 52 ; 53, 54) symétriques l'un par rapport à l'autre et combinés de façon que les sorties desdits premier et second multiplieurs translinéaires soient communes et constituent la sortie desdits moyens d'amplification,
et en ce que chacun desdits premier et second multiplieurs translinéaires (51, 52 ; 53, 54) comprend deux transistors d'entrée (T1, T2 ; T'1, T'2) et au moins une paire différentielle de transistors de sortie (T3, T4 ; T'3, T'4).

7. Chaîne d'amplification selon la revendication 6, caractérisée en ce que lesdits moyens d'amplification (21) de ladite première cellule de gain (12₁) comprennent :
- un premier étage de polarisation (81) comprenant notamment au moins deux premiers miroirs de courant ((M1_{A}, M1_{B}), (M2_{A}, M2_{B})) constitués chacun de deux transistors et permettant une polarisation de la ou des paires différentielles de transistors de sortie (T3, T4) dudit premier multiplieur translinéaire (82) et constituant une masse virtuelle pour les transistors d'entrée (T1, T2) dudit premier multiplieur translinéaire (82) ;
- un étage complémentaire d'amplification (84) comprenant notamment au moins deux seconds miroirs de courant ((M5_{A}, M5_{B}), (M6_{A}, M6_{B})), constitués chacun de deux transistors, lesdits seconds miroirs de courant recevant ledit courant d'entrée de la chaîne d'amplification et le copiant afin de le transmettre auxdits premiers miroirs de courant dudit premier étage de polarisation d'une part, deux desdits transistors constituant lesdits seconds miroirs de courant étant transformés en une paire différentielle de transistors de sortie (M5_{B}, M6_{B}) d'autre part, lorsque ledit étage complémentaire d'amplification (84) est activé ;
- des moyens d'activation (C₂) dudit étage complémentaire d'amplification (84) en fonction de la fréquence du courant d'entrée de la chaîne d'amplification, ledit étage comlémentaire d'amplification étant activé en hautes fréquences et désactivé en basses fréquences;
- un second étage de polarisation (85) comprenant notamment :
* au moins deux troisièmes miroirs de courant ((M3_{A}, M3_{B}), (M4_{A}, M4_{B})) constitués chacun de deux transistors et permettant, lorsque ledit second étage de polarisation n'est pas désactivé, une polarisation de la ou des paires différentielles de transistors de sortie (T3', T4') dudit second multiplieur translinéaire (83) ;
* au moins deux quatrièmes miroirs de courant ((M3_{A}, M3_{B}'), (M4_{A}, M4_{B}')) constitués chacun de deux transistors, lesdits quatrièmes miroirs de courant recevant ledit courant d'entrée de la chaîne d'amplification et le copiant afin de le transmettre auxdits premiers miroirs de courant dudit premier étage de polarisation lorsque ledit second étage de polarisation n'est pas désactivé ; et
- des moyens de désactivation (C1) dudit second étage de polarisation (85) en fonction de la fréquence du courant d'entrée de la chaîne d'amplification, ledit second étage de polarisation étant désactivé en hautes fréquences et activé en basses fréquences.

8. Chaîne d'amplification selon la revendication 7, caractérisée en ce que lesdits moyens d'amplification de ladite seconde cellule de gain (12₂ à 12ₙ) comprennent :
- un premier étage de polarisation (91) comprenant notamment au moins deux premiers miroirs de courant ((M1_{A}, M1_{B}), (M2_{A}, M2_{B})) constitués chacun de deux transistors et permettant une polarisation de la ou des paires différentielles de transistors de sortie (T3, T4) dudit premier multiplieur translinéaire (92) et constituant une masse virtuelle pour les transistors d'entrée (T1, T2) dudit premier multiplieur translinéaire (92) ;
- un étage complémentaire d'amplification (94) comprenant au moins deux transistors (M5_{C}, M6_{C}) reliés chacun à un des transistors (M5_{A}, M6_{A}) desdits seconds miroirs de courant ((M5_{A}, M5_{B}), (M6_{A}, M6_{B})) de ladite première cellule de gain de façon à constituer au moins deux cinquièmes miroirs de courant ((M5_{A}, M5_{C}), (M6_{A}, M6_{C})), lesdits cinquièmes miroirs de courant recevant ledit courant d'entrée de la chaîne d'amplification et le copiant afin de le transmettre auxdits premiers miroirs de courant dudit premier étage de polarisation de la seconde cellule de gain d'une part, lesdits transistors de l'étage complémentaire d'amplification étant transformés en une paire différentielle de transistors de sortie (M5_{C}, M6_{C}) d'autre part, lorsque ledit étage complémentaire d'amplification (94) est activé;
- des moyens d'activation (C2') dudit étage complémentaire d'amplification (94) en fonction de la fréquence du courant d'entrée de la chaîne d'amplification, ledit étage comlémentaire d'amplification étant activé en hautes fréquences et désactivé en basses fréquences;
- un second étage de polarisation (95) comprenant notamment :
* au moins deux transistors (M3_{C}, M4_{C}) reliés chacun à un des transistors (M3_{A}, M4_{A}) desdits troisièmes miroirs de courant ((M3_{A}, M3_{B}), (M4_{A}, M4_{B})) de ladite première cellule de gain de façon à constituer au moins deux sixièmes miroirs de courant ((M3_{A}, M3_{C}), (M4_{A}, M4_{C})) permettant, lorsque le second étage de polarisation de la première cellule de gain n'est pas désactivé, une polarisation de la ou des paires différentielles de transistors de sortie (T3', T4') dudit second multiplieur translinéaire (93) de la seconde cellule de gain ;
* au moins deux transistors (M3_{C}', M4_{C}') reliés chacun à un des transistors (M3_{A}, M4_{A}) desdits quatrièmes miroirs de courant ((M3_{A}, M3_{B}'), (M4_{A}, M4_{B}')) de ladite première cellule de gain de façon à constituer au moins deux septièmes miroirs de courant recevant ledit courant d'entrée de la chaîne d'amplification et le copiant afin de le transmettre auxdits premiers miroirs de courant dudit premier étage de polarisation de la seconde cellule de gain, lorsque le second étage de polarisation de la première cellule de gain n'est pas désactivé,
et en ce que lesdites première et seconde entrées des moyens d'amplification de ladite seconde cellule de gain sont situées au niveau respectivement dudit second multiplieur translinéaire (93) et dudit étage complémentaire d'amplification (94), lesdits moyens d'activation (C2') de l'étage complémentaire d'amplification (94) de la seconde cellule de gain constituant lesdits moyens d'activation/désactivation de la seconde entrée des moyens d'amplification de ladite seconde cellule de gain.

9. Chaîne d'amplification selon l'une quelconque des revendications 1 à 8, caractérisée en ce que lesdits moyens de filtrage passe-bas de chacune desdites première et seconde cellules de gain (12₁ à 12ₙ) comprennent deux couples d'éléments passifs constitués chacun d'une résistance (R_{f}) et un condensateur (C_{f}).

10. Chaîne d'amplification selon l'une quelconque des revendications 8 et 9, caractérisée en ce que les moyens d'activation (C2) de l'étage complémentaire d'amplification (84) de la première cellule de gain, les moyens de désactivation (C1) du second étage de polarisation (85) de la première cellule de gain, et les moyens d'activation (C2') de l'étage complémentaire d'amplification (94) de la seconde cellule de gain sont constitués d'au moins un condensateur (C2, C1 ; C2').

11. Chaîne d'amplification selon l'une quelconque des revendications 1 à 10, caractérisée en ce que lesdits transistors appartiennent au groupe comprenant les transistors bipolaires et les transistors MOS.

12. Chaîne d'amplification selon la revendication 11 et l'une quelconque des revendications 7 à 10, caractérisée en ce que, pour chacune desdites première et seconde cellules de gain (12₁ à 12ₙ) :
- les transistors mis en oeuvre dans le premier multiplieur translinéaire (82 ; 92) et le premier étage de polarisation (81 ; 91) sont du type PMOS, et
- les transistors mis en oeuvre dans le second multiplieur translinéaire (83 ; 93), l'étage complémentaire d'amplification (84 ; 94) et le second étage de polarisation (85 ; 95) sont du type NMOS.

13. Chaîne d'amplification selon la revendication 11 et l'une quelconque des revendications 7 à 10, caractérisée en ce que, pour chacune des cellules de gain (12₁ à 12ₙ) :
- les transistors mis en oeuvre dans le premier multiplieur translinéaire (82 ; 92) et le premier étage de polarisation (81 ; 91) sont du type PNP, et
- les transistors mis en oeuvre dans le second multiplieur translinéaire (83 ; 93), l'étage complémentaire d'amplification (84 ; 94) et le second étage de polarisation (85 ; 95) sont du type NPN.

14. Amplificateur opérationnel caractérisé en ce qu'il intègre une chaîne d'amplification (11) en mode de courant selon l'une quelconque des revendications de 1 à 13.

15. Cellule de gain (12₁ à 12ₙ) dans une chaîne d'amplification (11) en mode de courant selon l'une quelconque des revendications 1 à 13,
caractérisée en ce qu'elle comprend des moyens d'amplification constituées notamment de deux multiplieurs translinéaires symétriques l'un par rapport à l'autre et combinés de façon que les sorties desdits multiplieurs translinéaires soient communes et constituent la sortie desdits moyens d'amplification.

16. Elément d'amplification du type bâti autour d'un multiplieur translinéaire, mis en oeuvre dans une cellule de gain selon la revendication 15,
caractérisé en ce qu'il comprend au moins un étage de polarisation constitué notamment de deux miroirs de courant permettant une polarisation d'une ou plusieurs paires différentielles de transistors de sortie dudit multiplieur translinéaire et constituant une masse virtuelle pour les transistors d'entrée dudit multiplieur translinéaire.

## Patentansprüche

1. Verstärkerkette im Strommodus (11), **dadurch gekennzeichnet**, dass sie eine erste Verstärkungszelle (12₁) und wenigstens eine zweite Verstärkungszelle (12₂ bis 12ₙ) umfasst, die kaskadenförmig angeordnet sind:
wobei die erste Verstärkungszelle (12₁) umfasst:
- Verstärkungsmittel (21), die einen Eingangsstrom (15) der Verstärkerkette (11) empfangen und einen verstärkten Ausgangsstrom (24) liefern;
- Mittel (22) zur Tiefpassfilterung, die den verstärkten Ausgangsstrom (24) der Verstärkermittel (21) er ersten Verstärkungszelle empfangen und einen verstärkten und gefilterten Ausgangsstrom (25) liefern;
wobei die zweite Verstärkungszelle (12₂ bis 12ₙ) umfasst:
- Verstärkungsmittel (26), die einerseits einen ersten Eingang (EINGANG 1), der den verstärkten und gefilterten Ausgangsstrom (25; 211) der in der Kaskade vorhergehenden Zelle empfängt, und andererseits einen zweiten Eingang (EINGANG 2) aufweist, der den Eingangsstrom (15) der Verstärkerkette empfängt und einen verstärkten Ausgangsstrom (210) liefert;
- Mittel (27) zur Aktivierung/Deaktivierung des zweiten Eingangs (EINGANG 2);
- Mittel (28) zur Tiefpassfilterung, die den verstärkten Ausgangsstrom (210) der Verstärkermittel (26) der zweiten Verstärkungszelle empfangen und einen verstärkten und gefilterten Ausgangsstrom (211) liefern, und dass die Mittel (28) zur Tiefpassfilterung jeder der kaskadenförmig angebrachten Verstärkungszellen eine obere Grenzfrequenz (f_{h,i}) besitzen, wobei die zunehmende Ordnung der oberen Grenzfrequenzen der Kaskadenordnung der Verstärkungszellen (12₁ bis 12ₙ) vom Eingang zum Ausgang der Verstärkerkette (11) entsprechen.

2. Verstärkerkette nach Anspruch 1, dadurch gekennzeichnet, dass die Mittel (27) zur Aktivierung/Deaktivierung des zweiten Eingangs der Verstärkungsmittel der zweiten Verstärkungszelle vom Hochpasstyp sind und eine untere Grenzfrequenz besitzen, wobei der zweite Eingang für die Frequenzen, die höher als die untere Grenzfrequenz sind, aktiviert wird und für die anderen Frequenzen deaktiviert wird, wobei die zunehmende Ordnung der unteren Grenzfrequenzen der Kaskadenordnung der Verstärkungszellen vom Eingang zum Ausgang der Verstärkerkette (11) entsprechen.

3. Verstärkerkette nach Anspruch 2, dadurch gekennzeichnet, dass die untere Grenzfrequenz der Mittel (27) zur Aktivierung/Deaktivierung des zweiten Eingangs der zweiten Verstärkungszelle im Wesentlichen niedriger als die obere Grenzfrequenz (f_{h,i}) der Mittel (22; 28) zur Tiefpassfilterung der vorhergehenden Verstärkungszelle ist.

4. Verstärkerkette nach einem der Ansprüche 1 bis 3, dadurch gekennzeichnet, dass sie eine Eingangszelle (13) umfasst, die stromaufwärts der Kaskade von Verstärkungszellen (12₁ bis 12ₙ) angeordnet ist und den Eingangsstrom der Verstärkerkette empfängt, wobei die Eingangszelle (13) eine sehr geringe Eingangsimpedanz besitzt, und dass die Eingangszelle (13) Additionsmittel umfasst und einen Strom liefert, der gleich der Summe des Eingangsstrom der Verstärkerkette (11) und eines kontinuierlichen Polarisationsstroms (I₀) ist.

5. Verstärkerkette nach einem der Ansprüche 1 bis 4, dadurch gekennzeichnet, dass sie eine Ausgangszelle (14) aufweist, die stromabwärts der Kaskade von Verstärkungszellen (12₁ bis 12ₙ) angeordnet ist und den Ausgangsstrom der letzten Verstärkungszelle (12ₙ) empfängt, wobei die Ausgangszelle (14) eine sehr hohe Ausgangsimpedanz besitzt.

6. Verstärkerkette nach einem der Ansprüche 1 bis 5, dadurch gekennzeichnet, dass die Verstärkungsmittel (21; 26) jeder der ersten und zweiten Verstärkungszellen ein erstes und ein zweites translineares Multiplikatorwerk (51, 52; 53, 54) umfassen, die zueinander symmetrisch und so kombiniert sind, dass die Ausgänge der ersten und zweiten translinearen Multiplikatorwerke gemeinsam sind und den Ausgang der Verstärkermittel bilden, und dass jedes er ersten und zweiten translinearen Multiplikatorwerke (51, 52; 53, 54) zwei Eingangstransistoren (T1, T2; T'1, T'2) und wenigstens ein differentielles Paar von Ausgangstransistoren (T3, T4; T'3, T'4) umfasst.

7. Verstärkerkette nach Anspruch 6, dadurch gekennzeichnet, dass die Verstärkungsmittel (21) der ersten Verstärkungszelle (12₁) umfassen:
- eine erste Polarisationsstufe (81), die insbesondere wenigstens zwei erste Stromspiegel ((M1_{A}, M1_{B}), (M2_{A}, M2_{B})) umfasst, die jeweils aus zwei Transistoren bestehen, und eine Polarisation des oder der differentiellen Paare von Ausgangstransistoren (T3, T4) des ersten translinearen Multiplikatorwerks (82) gestatten und für die Eingangstransistoren (T1, T2) des ersten translinearen Multiplikatorwerks (82) eine virtuelle Masse bilden;
- eine komplementäre Verstärkerstufe (84), die insbesondere wenigstens zwei zweite Stromspiegel ((M5_{A}, M5_{B}), (M6_{A}, M6_{B})) umfasst, die jeweils aus zwei Transistoren bestehen, wobei die zweiten Stromspiegel einerseits den Eingangsstrom der Verstärkerkette empfangen und ihn kopieren, um ihn zu den ersten Stromspiegeln der ersten Polarisationsstufe zu übertragen, wobei andererseits zwei der Transistoren, die die zweiten Stromspiegel bilden, in ein differentielles Paar von Ausgangstransistoren (M5_{B}, M6_{B}) umgewandelt wird, wenn die komplementäre Verstärkerstufe (84) aktiviert ist;
- Mittel (C2) zur Aktivierung der komplementären Verstärkerstufe (84) in Abhängigkeit von der Frequenz des Eingangsstroms der Verstärkerkette, wobei die komplementäre Verstärkerstufe bei hohen Frequenzen aktiviert und bei niedrigen Frequenzen deaktiviert wird;
- eine zweite Polarisationsstufe (85), die insbesondere umfasst:
* wenigstens zwei dritte Stromspiegel ((M3_{A}, M3_{B}), (M4_{A}, M4_{B})), die jeweils aus zwei Transistoren bestehen und eine Polarisation des oder der differentiellen Paare von Ausgangstransistoren (T3', T4') des zweiten translinearen Multiplikatorwerks (83) gestatten, wenn die zweite Polarisationsstufe nicht deaktiviert ist;
* wenigstens zwei vierte Stromspiegel ((M3_{A}, M3_{B}'), (M4_{A}, M4_{B}')), die jeweils aus zwei Transistoren bestehen, wobei die vierten Stromspiegel den Eingangsstrom der Verstärkerkette empfangen und ihn kopieren, um ihn zu den ersten Stromspiegeln der ersten Polarisationsstufe zu übertragen, wenn die zweite Polarisationsstufe nicht deaktiviert ist; und
- Mittel (C1) zur Deaktivierung der zweiten Polarisationsstufe (85) in Abhängigkeit von der Frequenz des Eingangsstroms der Verstärkerstufe, wobei die zweite Polarisationsstufe bei hohen Frequenzen deaktiviert und bei niedrigen Frequenzen aktiviert ist.

8. Verstärkerkette nach Anspruch 7, dadurch gekennzeichnet, dass die Verstärkungsmittel er zweiten Verstärkungszelle (12₂ bis 12ₙ) umfassen:
- eine erste Polarisationsstufe (91), die insbesondere wenigstens zwei erste Stromspiegel ((M1_{A}, M1_{B}), (M2_{A}, M2_{B})) umfasst, die jeweils aus zwei Transistoren bestehen, und eine Polarisation des oder der differentiellen Paare von Ausgangstransistoren (T3, T4) des ersten translinearen Multiplikatorwerks (92) gestatten und für die Eingangstransistoren (T1, T2) des ersten translinearen Multiplikatorwerks (92) eine virtuelle Masse bilden;
- eine komplementäre Verstärkerstufe (94), die wenigstens zwei Transistoren (M5_{C}, M6_{C}) umfasst, die jeweils mit einem der Transistoren (M5_{A}, M6_{A}) der zweiten Stromspiegel ((M5_{A}, M5_{B}), (M6_{A}, M6_{B})) der ersten Verstärkungszelle so verbunden sind, dass wenigstens zwei fünfte Stromspiegel ((M5_{A}, M5_{C}), (M6_{A}, M6_{C})) gebildet werden, wobei die fünften Stromspiegel einerseits den Eingangsstrom der Verstärkerkette empfangen und ihn kopieren, um ihn zu den ersten Stromspiegel der ersten Polarisationsstufe der zweiten Verstärkungszelle zu übertragen, wobei andererseits die Transistoren der komplementären Verstärkerstufe in ein differentielles Paar von Ausgangstransistoren (M5_{C}, M6_{C}) umgewandelt werden, wenn die komplementäre Verstärkerstufe (94) aktiviert ist;
- Mittel (C2') zur Aktivierung der komplementären Verstärkerstufe (94) in Abhängigkeit von der Frequenz des Eingangsstroms der Verstärkerkette, wobei die komplementäre Verstärkerstufe bei hohen Frequenzen aktiviert und bei niedrigen Frequenzen deaktiviert wird;
- eine zweite Polarisationsstufe (95), die insbesondere umfasst:
* wenigstens zwei Transistoren (M3_{C}, M4_{C}), die jeweils mit einem der Transistoren (M3_{A}, M4_{A}) der dritten Stromspiegel ((M3_{A}, M3_{B}), (M4_{A}, M4_{B})) der ersten Verstärkungszelle so verbunden sind, dass wenigstens zwei sechste Stromspiegel ((M3_{A}, M3_{C}), (M4_{A}, M4_{C})) gebildet werden, die eine Polarisation des oder der differentiellen Paare von Ausgangstransistoren (T3', T4') des zweiten translinearen Multiplikatorwerks (93) der zweiten Verstärkungszelle gestatten, wenn die zweite Polarisationsstufe der ersten Verstärkungszelle nicht deaktiviert ist;
* wenigstens zwei Transistoren (M3_{C}, M4_{C}'), die jeweils mit einem der Transistoren (M3_{A}, M4_{A}) der vierten Stromspiegel ((M3_{A}, M3_{B}'), (M4_{A}, M4_{B}')) der ersten Verstärkungszelle so verbunden sind, dass wenigstens zwei siebte Stromspiegel gebildet werden, die den Eingangsstrom der Verstärkerkette empfangen und ihn kopieren, um ihn zu den ersten Stromspiegeln der ersten Polarisationsstufe der zweiten Verstärkungszelle zu übertragen, wenn die zweite Polarisationsstufe der ersten Verstärkungszelle nicht deaktiviert ist;
und dass sich die ersten und zweiten Eingänge der Verstärkungsmittel der zweiten Verstärkungszelle in Höhe des zweiten translinearen Multiplikatorwerks (93) bzw. der komplementären Verstärkerstufe (94) der zweiten Verstärkungszelle befinden, die die Mittel zur Aktivierung/Deaktivierung des zweiten Eingangs der Verstärkungsmittel der zweiten Verstärkungszelle bildet.

9. Verstärkerkette nach einem der Ansprüche 1 bis 8, dadurch gekennzeichnet, dass die Mittel zur Tiefpassfilterung jeder der ersten und zweiten Verstärkungszellen (12₁ bis 12ₙ) zwei Paare von passiven Elementen aufweisen, die jeweils aus einem Widerstand (R_{f}) und einem Kondensator (C_{f}) bestehen.

10. Verstärkerkette nach einem der Ansprüche 8 und 9, dadurch gekennzeichnet, dass die Mittel (C2) zur Aktivierung der komplementären Verstärkerstufe (84) der ersten Verstärkungszelle, die Mittel (C1) zur Deaktivierung der zweiten Polarisationsstufe (85) der ersten Verstärkungszelle und die Mittel (C2') zur Aktivierung der komplementären Verstärkerstufe (94) der zweiten Verstärkungszelle aus wenigstens einem Kondensator (C2, C1; C2') bestehen.

11. Verstärkerkette nach einem der Ansprüche 1 bis 10, dadurch gekennzeichnet, dass die Transistoren zu der Gruppe gehören, die die bipolaren Transistoren und die MOS-Transistoren umfasst.

12. Verstärkerkette nach Anspruch 11 und einem der Ansprüche 7 bis 10, dadurch gekennzeichnet, dass für jede der ersten und zweiten Verstärkungszellen (12₁ bis 12ₙ) :
- die im ersten translinearen Multiplikatorwerk (82; 92) und der ersten Polarisationsstufe (81; 91) eingesetzten Transistoren vom PMOS-Typ sind und
- die im zweiten translinearen Multiplikatorwerk (83; 93), der komplementären Verstärkerstufe (84; 94) und der zweiten Polarisationsstufe (85; 95) vom NMOS-Typ sind.

13. Verstärkerkette nach Anspruch 11 und einem der Ansprüche 7 bis 10, dadurch gekennzeichnet, dass für jede der Verstärkungszellen (12₁ bis 12ₙ) :
- die im ersten translinearen Multiplikatorwerk (82; 92) und der ersten Polarisationsstufe (81; 91) eingesetzten Transistoren vom PNP-Typ sind und
- die im zweiten translinearen Multiplikatorwerk (83; 93), der komplementären Verstärkerstufe (84; 94) und der zweiten Polarisationsstufe (85; 95) vom NPN-Typ sind.

14. Operationsverstärker, dadurch gekennzeichnet, dass er eine Verstärkerkette (11) im Strommodus nach einem der Ansprüche 1 bis 13 integriert.

15. Verstärkungszelle (12₁ bis 12ₙ) in einer Verstärkerkette (11) im Strommodus nach einem der Ansprüche 1 bis 13,
dadurch gekennzeichnet, dass sie Verstärkermittel umfasst, die insbesondere aus zwei translinearen Multiplikatorwerken bestehen, die zueinander symmetrisch und so kombiniert sind, dass die Ausgänge der translinearen Multiplikatorwerke gemeinsam sind und den Ausgang der Verstärkermittel bilden.

16. Verstärkungselement vom Typ eines Rahmens um ein translineares Multiplikatorwerk herum, das in einer Verstärkungszelle nach Anspruch 15 eingesetzt wird, dadurch gekennzeichnet, dass es wenigstens eine Polarisationsstufe umfasst, die insbesondere aus zwei Stromspiegeln besteht, die eine Polarisation einer oder mehrerer differentieller Paare von Ausgangstransistoren des translinearen Multiplikatorwerks gestatten und für die Eingangstransistoren des translinearen Multiplikatorwerks eine virtuelle Masse bilden.

## Claims

1. A current-mode amplification system (11), characterized in that it includes a first gain section (12₁) and at least one second gain section (12₂ to 12ₙ) chained together to form a chain of gain sections;
said first gain section (12₁) comprising:
- amplification means (21) receiving an input current (15) which is the input current of said amplification system (11), and delivering an amplified output current (24); and
- low-pass filtering means (22) receiving said amplified output current (24) from said amplification means (21) of said first gain section, and delivering an amplified and filtered output current (25);
said second gain section (12₂ to 12ₙ) comprising:
- amplification means (26) having firstly a first input (INPUT 1) receiving the amplified and filtered output current (25; 211) from the preceding gain section in said chain, and secondly a second input (INPUT 2) receiving the input current (15) of said amplification system, and delivering an amplified output current (210);
- activation/deactivation means (27) for activating/deactivating said second input (INPUT 2); and
- low-pass filtering means (28) receiving said amplified output current (210) from said amplification means (26) of said second gain section, and delivering an amplified and filtered output current (211);
and in that said low-pass filtering means (28) of each of said chained-together gain sections has a high cut-off frequency (f_{h,i}), the high cut-off frequencies of the various gain sections (12₁ to 12ₙ) increasing from the input to the output of said amplification system (11).

2. An amplification system according to claim 1, characterized in that said activation/deactivation means (27) for activating/deactivating the second input of the amplification means of said second gain section are of the high-pass type, and they have a low cut-off frequency, said second input being activated for frequencies that are higher than said low cut-off frequency, and being deactivated for the other frequencies, said low cut-off frequencies increasing from the input to the output of said amplification system (11).

3. An amplification system according to claim 2, characterized in that the low cut-off frequency of the activation/deactivation means (27) for activating/deactivating said second input of the second gain section is significantly lower than the high cut-off frequency (f_{h,i}) of the low-pass filtering means (22; 28) of the preceding gain section.

4. An amplification system according to any one of claims 1 to 3, characterized in that it includes an input section (13), placed upstream from said chain of gain sections (12₁ to 12ₙ) and receiving said input current of the amplification system, said input section (13) having a very low input impedance;
and in that said input section (13) includes adding means and delivers a current equal to the sum of the input current of the amplification system (11) and of a DC bias current (Iₒ).

5. An amplification system according to any one of claims 1 to 4, characterized in that it includes an output section (14) placed downstream from said chain of gain sections (12₁ to 12ₙ) and receiving the current output by the last gain section (12ₙ), said output section (14) having a very high output impedance.

6. An amplification system according to any one of claims 1 to 5, characterized in that said amplification means (21; 26) of each of said first and second gain sections comprise a first translinear multiplier (51, 53) and a second translinear multiplier (52, 54) that are symmetrical relative to each other and that are combined so that said first and second translinear multipliers have a common output which constitutes the output of said amplification means;
and in that each of said first and second translinear multipliers (51, 52; 53, 54) include two input transistors (T1, T2; T'1, T'2) and at least one differential pair of output transistors (T3, T4; T'3, T'4).

7. An amplification system according to claim 6, characterized in that said amplification means (21) of said first gain section (12₁) comprise:
- a first bias stage (81) including in particular at least two first current mirrors ((M1_{A}, M1_{B}), (M2_{A}, M2_{B})), each of which is constituted by two transistors, the first bias stage enabling the differential pair(s) of output transistors (T3, T4) of said first translinear multiplier (82) to be biassed, and constituting a virtual ground for the input transistors (T1, T2) of said first translinear multiplier (82);
- an additional amplification stage (84) including in particular at least two second current mirrors ((M5_{A}, M5_{B}), (M6_{A}, M6_{B})), each of which is constituted by two transistors, said second current mirrors receiving said input current of the amplification system and copying it so as to transmit it to said first current mirrors of said first bias stage, and two of said transistors constituting said second current mirrors being transformed into a differential pair of output transistors (M5_{B}, M6_{B}), when said additional amplification stage (84) is activated;
- activation means (C2) for activating said additional amplification stage (84) as a function of the frequency of the input current of the amplification system, said additional amplification stage being activated at high frequencies, and deactivated at low frequencies;
- a second bias stage (85), including in particular:
· at least two third current mirrors ((M3_{A}, M3_{B}), (M4_{A}, M4_{B})), each of which is constituted by two transistors, the third current mirrors enabling the differential pair(s) of output transistors (T3', T4') of said second translinear multiplier (83) to be biassed, when said second bias stage is not deactivated; and
· at least two fourth current mirrors ((M3_{A}, M3_{B}'), (M4_{A}, M4_{B}')), each of which is constituted by two transistors, said fourth current mirrors receiving said input current of the amplification system and copying it so as to transmit it to said first current mirrors of said first bias stage when said second bias stage is not deactivated; and
- deactivation means (C1) for deactivating said second bias stage (85) as a function of the frequency of the input current of the amplification system, said second bias stage being deactivated at high frequencies and activated at low frequencies.

8. An amplification system according to claim 7, characterized in that said amplification means of said second gain section (12₂ to 12ₙ) comprise:
- a first bias stage (91) including in particular at least two first current mirrors ((M1_{A}, M1_{B}), (M2_{A}, M2_{B})), each of which is constituted by two transistors, the first bias stage enabling the differential pair(s) of output transistors (T3, T4) of said first translinear multiplier (92) to be biassed, and constituting a virtual ground for the input transistors (T1, T2) of said first translinear multiplier (92);
- an additional amplification stage (94) including at least two transistors (M5_{C}, M6C), each of which is connected to a respective one of the transistors (M5_{A}, M6_{A}) of said second current mirrors ((M5_{A}, M5_{B}), (M6_{A}, M6_{B})) of said first gain section so as to constitute at least two fifth current mirrors ((M5_{A}, M5_{C}), (M6_{A}, M6C)), said fifth current mirrors receiving said input current of the amplification system and copying it so as to transmit it to said first current mirrors of said first bias stage of the second gain section, and said transistors of the additional amplification stage being transformed into a differential pair of output transistors (M5_{C}, M6_{C}), when said additional amplification stage (94) is activated;
- activation means (C2') for activating said additional amplification stage (94) as a function of the frequency of the input current of the amplification system, said additional amplification stage being activated at high frequencies, and deactivated at low frequencies; and
- a second bias stage (95), including in particular:
· at least two transistors (M3_{C}, M4_{C}), each of which is connected to a respective one of the transistors (M3_{A}, M4_{A}) of said third current mirrors ((M3_{A}, M3_{B}), (M4_{A}, M4_{B})) of said first gain section so as to constitute at least two sixth current mirrors ((M3_{A}, M3_{C}), (M4_{A}, M4_{C})) enabling the differential pair(s) of output transistors (T3', T4') of said second translinear multiplier (93) of the second gain section to be biassed, when the second bias stage of the first gain section is not deactivated; and
· at least two transistors (M3_{C}', M4_{C}'), each of which is connected to a respective one of the transistors (M3_{A}, M4_{A}) of said fourth current mirrors ((M3_{A}, M3_{B}'), (M4_{A}, M4_{B}')) of said first gain section so as to constitute at least two seventh current mirrors receiving said input current of the amplification system and copying it so as to transmit it to said first current mirrors of said first bias stage of the second gain section, when the second bias stage of the first gain section is not deactivated;
and in that said first and second inputs of the amplification means of said second gain section are situated respectively at said second translinear multiplier (93) and at said additional amplification stage (94), said activation means (C2') for activating the additional amplification stage (94) of the second gain section constituting said activation/deactivation means for activating/deactivating the second input of the amplification means of said second gain section.

9. An amplification system according to any one of claims 1 to 8, characterized in that said low-pass filtering means of each of said first and second gain sections (12₁ to 12ₙ) comprise two pairs of passive elements, each pair being constituted by a resistor (R_{f}) and by a capacitor (C_{f}).

10. An amplification system according to claim 8 or 9, characterized in that the activation means (C2) for activating the additional amplification stage (84) of the first gain section, the deactivation means (C1) for deactivating the second bias stage (85) of the first gain section, and the activation means (C2') for activating the additional amplification stage (94) of the second gain section are constituted by at least one capacitor (C2, C1; C2').

11. An amplification system according to any one of claims 1 to 10, characterized in that said transistors belong to the group comprising bipolar transistors and MOS transistors.

12. An amplification system according to claim 11 and to any one of claims 7 to 10, characterized in that, for each of said first and second gain sections (12₁ to 12ₙ):
the transistors implemented in the first translinear multiplier (82; 92) and in the first bias stage (81; 91) are of the PMOS type, and
the transistors implemented in the second translinear multiplier (83; 93), in the additional amplification stage (84; 94), and in the second bias stage (85; 95) are of the NMOS type.

13. An amplification system according to claim 11 and to any one of claims 7 to 10, characterized in that, for each of the gain sections (12₁ to 12ₙ):
the transistors implemented in the first translinear multiplier (82; 92) and in the first bias stage (81; 91) are of the PNP type; and
the transistors implemented in the second translinear multiplier (83; 93), in the additional amplification stage (84; 94), and in the second bias stage (85; 95) are of the NPN type.

14. An operational amplifier characterized in that it incorporates a current-mode amplification system (11) according to any one of claims 1 to 13.

15. A gain section (12₁ to 12ₙ) in a current-mode amplification system (11) according to any one of claims 1 to 13;
said gain section being characterized in that it includes amplification means constituted in particular by two translinear multipliers that are symmetrical to each other and that are combined so that they have a common output constituting the output of said amplification means.

16. An amplification element of the type constructed around a translinear multiplier, implemented in a gain section according to claim 15;
said element being characterized in that it includes at least one bias stage constituted in particular by two current mirrors enabling one or more differential pairs of output transistors of said translinear multiplier to be biassed, and constituting a virtual ground for the input transistors of said translinear multiplier.
